# EUROPEAN PATENT APPLICATION

(11) **EP 4 443 518 A1**
(43) Date of publication of application: **09.10.2024**
(21) Application number: 23198431.1
(22) Date of filing: 20.09.2023
(51) Int. Cl.: H01L 29/737, H01L 21/331, H01L 29/06, H01L 29/87, H01L 29/78

(54) **LOW CAPACITANCE AND LOW RESISTANCE DEVICES**

(30) Priority: 06.04.2023 US 202318296521
(71) Applicant: GlobalFoundries U.S. Inc., Malta, NY 12020 (US)
(72) Inventor: HOLT, Judson R., Malta, NY, 12020 (US); PEKARIK, John J., Essex Junction, VT, 05452 (US); NATH, Anindya, Essex Junction, VT, 05452 (US); MITRA, Souvick, Essex Junction, VT, 05452 (US)
(74) Representative: Lambacher, Michael

(57) **Abstract**

The present disclosure relates to semiconductor structures and, more particularly, to low capacitance, low resistance devices and methods of manufacture. The structure includes: a semiconductor substrate; a device having an active region; and a porous semiconductor material within the semiconductor substrate and surrounding the active region of the device.

## Description

### BACKGROUND

The present disclosure relates to semiconductor structures and, more particularly, to low capacitance, low resistance devices and methods of manufacture.

A heterojunction bipolar transistor (HBT) is a type of bipolar junction transistor (BJT) which uses differing semiconductor materials for the emitter and base regions, creating a heterojunction. The HBT can handle signals of very high frequencies, up to several hundred GHz, which can be used in radio frequency (RF) systems, and in applications requiring a high power efficiency, such as RF power amplifiers in cellular phones.

### SUMMARY

In an aspect of the disclosure, a structure comprises: a semiconductor substrate; a device comprising an active region; and a porous semiconductor material within the semiconductor substrate and surrounding the active region of the device.

Additional features of the structure are set forth in dependent claims 2 to 9.

In an aspect of the disclosure, a structure comprises: a semiconductor material; a heterojunction bipolar transistor comprising: a collector region of defect free single crystalline semiconductor material over the semiconductor material; an intrinsic base region above the collector region; an extrinsic base region above the intrinsic base region; and an emitter above the intrinsic base region; and porous semiconductor material over the semiconductor material and surrounding at least the collector region.

Additional features of the structure are set forth in dependent claims 11 to 14.

In an aspect of the disclosure, a method comprises: forming a semiconductor substrate; forming a device comprising an active region; and forming a porous semiconductor material within the semiconductor substrate and surrounding the active region of the device.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a bipolar heterojunction (HBT) device and respective fabrication processes in accordance with aspects of the present disclosure.
FIG. 2 shows a CMOS device and respective fabrication processes in accordance with aspects of the present disclosure.
FIG. 3 shows a silicon controlled rectifier (SCR) device and respective fabrication processes in accordance with aspects of the present disclosure.
FIGS. 4A-4E show fabrication processes for manufacturing the device of FIG. 1 in accordance with aspects of the present disclosure.

### DETAILED DESCRIPTION

The present disclosure relates to semiconductor structures and, more particularly, to low capacitance, low resistance devices and methods of manufacture. In embodiments, the low capacitance, low resistance devices may be, for example, a heterojunction bipolar transistor, a CMOS transistor or silicon controlled rectifier (SCR), amongst other devices. In more specific embodiments, for example, the low capacitance, low resistance devices include a porous semiconductor material within a semiconductor substrate. Advantageously, by using the porous semiconductor material in a heterojunction bipolar transistor, for example, the device will exhibit lower collector/base capacitance and improved base resistance.

In more specific embodiments, for example, the low capacitance, low resistance heterojunction bipolar transistor (HBT) includes an intrinsic base region comprising single crystalline semiconductor material over a porous semiconductor material. The porous semiconductor material may be below the intrinsic base region and extrinsic base region. The intrinsic base region separates the extrinsic base region from a collector region comprising a defect free single crystalline semiconductor material.

The low capacitance, low resistance devices of the present disclosure can be manufactured in a number of ways using a number of different tools. In general, though, the methodologies and tools are used to form structures with dimensions in the micrometer and nanometer scale. The methodologies, i.e., technologies, employed to manufacture the low capacitance, low resistance devices of the present disclosure have been adopted from integrated circuit (IC) technology. For example, the structures are built on wafers and are realized in films of material patterned by photolithographic processes on the top of a wafer. In particular, the fabrication of the low capacitance, low resistance devices uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

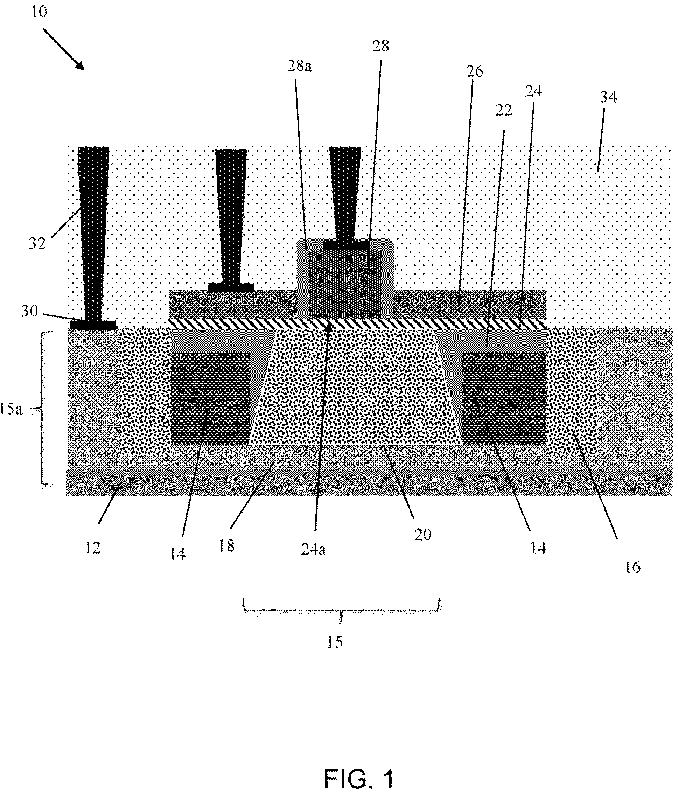

FIG. 1 shows a device and respective fabrication processes in accordance with aspects of the present disclosure. As an example, device 10 may be an HBT device. In embodiments, the device 10 includes a semiconductor substate 12 comprising any suitable semiconductor material including, but not limited to, Si, SiGe, SiGeC, SiC, GaAs, InAs, InP, and other III/V or II/VI compound semiconductors. In preferred embodiments, the semiconductor substate 12 may include single crystalline Si material with any suitable crystallographic orientation (e.g., a (100), (110), (111), or (001) crystallographic orientation).

Still referring to FIG. 1, porous semiconductor material 14 may be provided on the semiconductor substate 12. In embodiments, the porous semiconductor material 14 may be under base regions 24, 26 and surrounding (and, e.g., defining) a collector region 15 and emitter 28 of the heterojunction bipolar transistor. In additional embodiments, the porous semiconductor material 14 surrounds at least the intrinsic base region 24, which contacts the single crystalline Si material of the collector region 15. In preferred embodiments, the porous semiconductor material 14 comprises porous Si material; although other porous semiconductor material is contemplated for use herein. The porous semiconductor material 16 may be formed by, for example, electrochemical anodization or chemical etching of the single-crystal semiconductor material of the semiconductor substate 12.

The porous semiconductor material 14 may include a single-crystal matrix and interconnected pores distributed within the single-crystal matrix. The porous semiconductor material 14 may have a porosity characterized by a pore size that may range from a few nanometers to several hundreds of nanometers. The porous semiconductor material 14 may be free of crystalline grains and grain boundaries characteristic of a polycrystalline semiconductor material, such as polysilicon. In embodiments, the porous semiconductor material 14 may have an electrical resistivity that is greater than the electrical resistivity of the semiconductor material of the semiconductor substrate 12. For example, in embodiments, the porous semiconductor material 14 may have an electrical resistivity that is greater than 1000 ohm-cm.

FIG. 1 further shows shallow trench isolation structures 16 adjacent to (e.g., bounding) the porous semiconductor material 14 and within epitaxial semiconductor material 18. In embodiments, the epitaxial semiconductor material 18 may be provided in the collector region 15 and in a collector contact region 15a of the heterojunction bipolar transistor. In embodiments, the epitaxial semiconductor material 18 may be single crystalline semiconductor material. In more specific embodiments, the epitaxial semiconductor material 18 may be single crystalline Si material with a p-type dopant, e.g., boron.

A defect free single crystalline semiconductor material 20 may be provided between the shallow trench isolation structures 16 and, more specifically, between the porous semiconductor material 14. In embodiments, the defect free single crystalline semiconductor material 20 comprises and extends within the collector region 15 of the heterojunction bipolar transistor. The defect free single crystalline semiconductor material 20 may be epitaxial grown semiconductor material. In more specific embodiments, the defect free single crystalline semiconductor material 20 may be epitaxial grown Si material.

A defective semiconductor material 22 may be provided on the defect free single crystalline semiconductor material 20 and over the porous semiconductor material 14. In embodiments, the defective semiconductor material 22 may be epitaxial grown Si material grown with the defect free single crystalline semiconductor material 20. The defective semiconductor material 22 is provided between the base regions 24, 26 and the porous semiconductor material 14; that is, the defective semiconductor material 22 separates the base regions 24, 26 from the porous semiconductor material 14. In embodiments, the defective semiconductor material 22 may have, for example, a lattice mismatch or misfit dislocation compared to the defect free single crystalline semiconductor material 20. As should be understood by those of ordinary skill in the art, the defective semiconductor material 22 may have defects due to being grown from and in contact with the porous semiconductor material 14.

The base regions 24, 26 comprise an intrinsic base region 24 and an extrinsic base region 26. The intrinsic base region 24 may be provided in contact with both the defect free single crystalline semiconductor material 20 in the collector region 15 and the defective semiconductor material 22 over the porous semiconductor material 14. Accordingly, the intrinsic base region 24a separates the collector region 15 from the extrinsic base region 26.

In embodiments, the intrinsic base region 24 may be p-doped (or implanted) SiGe material or Si material. The extrinsic base region 26 may be single crystalline Si material and, more preferably, heavily doped (or implanted) p-type single crystalline Si material. In alternative embodiments, the extrinsic base region 26 may be n-doped SiGe material. In embodiments, the p-dopant (or implant) of the extrinsic base region 26 may be boron.

FIG. 1 further shows an emitter 28 and a sidewall spacer 28a around the emitter 20. The emitter 28, for example, is provided on the intrinsic base region 24 and the extrinsic base region 26. The sidewall spacer 28a may comprise oxide or nitride, as examples, which isolates the emitter 28 from the extrinsic base region 26. In embodiments, the emitter 28 may comprise a single crystalline semiconductor material with n-type dopant (or implant). For example, the n-type dopant (or implanted) may be arsenic; although other dopants are also contemplated herein as described below.

An interlevel dielectric material 34 may be formed over the emitter 28, base regions 24, 26 and any exposed semiconductor substate 12. The interlevel dielectric material 34 may be alternating layers of oxide and nitride, as an example, deposited by a conventional deposition method, e.g., chemical vapor deposition (CVD). Contacts 32 may be electrically connected to the collector contact region 15a, the extrinsic base region 26 and the emitter 28. In embodiments, the contacts 32 may be formed on respective silicide contacts 30. The contacts 32 may be, for example, tungsten with a TiN or TaN liner; although other metal or metal alloys as is known in the art is contemplated for use herein.

The contacts 32 may be formed by conventional lithography, etching and deposition methods known to those of skill in the art. For example, a resist formed over the interlevel dielectric material 34 is exposed to energy (light) and developed utilizing a conventional resist developer to form a pattern (opening). An etching process with a selective chemistry, e.g., reactive ion etching (RIE), will be used to transfer the pattern to form one or more trenches in the interlevel dielectric material 34 through the openings of the resist, thereby exposing the collector contact region 15a, the extrinsic base region 26 and the emitter 28. Following the resist removal by a conventional oxygen ashing process or other known stripants, conductive material can be deposited by any conventional deposition processes, e.g., CVD processes. Any residual material on the surface of the interlevel dielectric material 34 can be removed by conventional chemical mechanical polishing (CMP) processes.

Also, as should be understood by those of skill in the art, prior to the deposition of the conductive material within the one or more trenches of the interlevel dielectric material 34, the silicide process may be performed with deposition of a thin transition metal layer, e.g., nickel, cobalt or titanium, over the exposed and fully formed semiconductor devices (e.g., collector contact region 15a, the extrinsic base region 26 and the emitter 28). After deposition of the material, the structure is heated allowing the transition metal to react with exposed silicon (or other semiconductor material as described herein) in the active regions of the semiconductor device (e.g., source, drain, gate contact region) forming a low-resistance transition metal silicide. Following the reaction, any remaining transition metal is removed by chemical etching, leaving silicide contacts 30 in the active regions of the device.

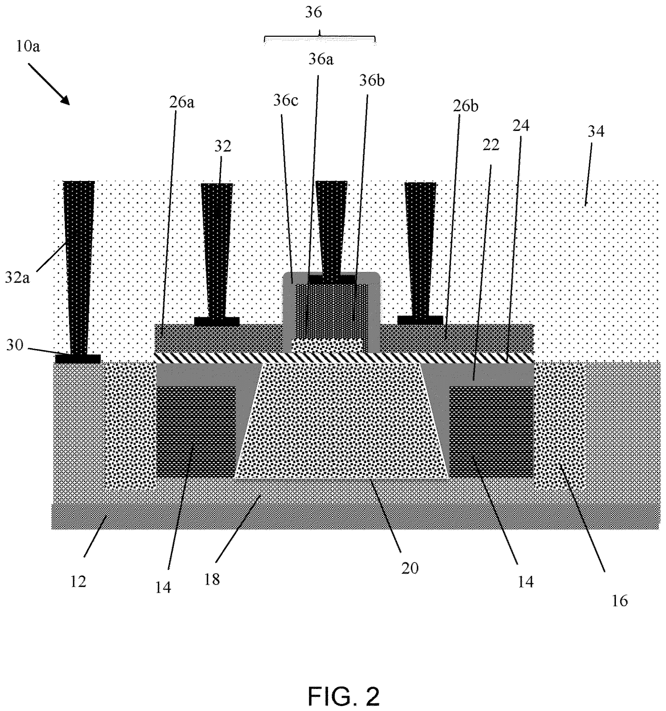

FIG. 2 shows a CMOS device and respective fabrication processes in accordance with aspects of the present disclosure. More specifically, the CMOS device 10a includes a gate structure 36 over a semiconductor material 24, e.g., Si material. In embodiments, the semiconductor material 24 may act as a channel region of the gate structure 36 between a source region 26a and a drain region 26b. In embodiments, the gate structure 36 (including, in embodiments, the semiconductor material 24) may be be over and surrounded by the porous semiconductor material 14.

The gate structure 36 may include gate dielectric material 36a, a gate electrode 36b and sidewall spacers 36c. The gate dielectric material 36a may be, for example, a low-k or high-k gate dielectric material, e.g., HfO₂ Al₂O₃, Ta₂O₃, TiO₂, La₂O₃, SrTiO₃, LaAlO₃, ZrO₂, Y₂O₃, Gd₂O₃, and combinations including multilayers thereof. The gate electrode 36b may be a polysilicon material or a known workfunction metal(s), e.g., Ti, TiAlC, Al, TiAl, TaN, TaAlC, TiN, TiC, C, etc. The sidewall spacers 36c may be an oxide or nitride material, blanket deposited over the gate electrode 36b by a conventional deposition method, e.g., CVD, followed by conventional patterning processes, e.g., lithography and etching processes.

The source region 26a and the drain region 26b may be raised source and drain regions, formed by a conventional epitaxial growth process with an in-situ dopant. Alternatively, the source region 26a and the drain region 26b may be diffusion regions in the semiconductor material 24, implanted using conventional ion implantation processes as is known in the art and described herein. Source and drain contacts 32 may be provided to the source region 26a and the drain region 26b. A back gate contact 32a may be provided to the semiconductor substrate 12 adjacent to the porous semiconductor material 14.

Although not critical to the understanding of the present disclosure, the gate structure 36 and accompanying diffusion regions (e.g., the source region 26a and the drain region 26b) can be fabricated using conventional CMOS processes. For example, the gate structure 36 can be fabricated using standard CMOS or replacement gate processes. In the standard CMOS processing, a gate dielectric 36a and gate electrode 36b, e.g., polysilicon or workfunction metal(s), are deposited onto the semiconductor material 24, followed by patterning processes. An insulator material such as nitride or oxide can be deposited on the patterned materials, followed by an anisotropic etching process to form sidewall spacers 36. The source region 26a and the drain region 26b can be epitaxially grown or ion implanted on the semiconductor material 24, adjacent to the sidewall spacers 36c. As should be understood, the sidewall spacers 36c will isolate the gate electrode 36b from the source region 26a and the drain region 26b.

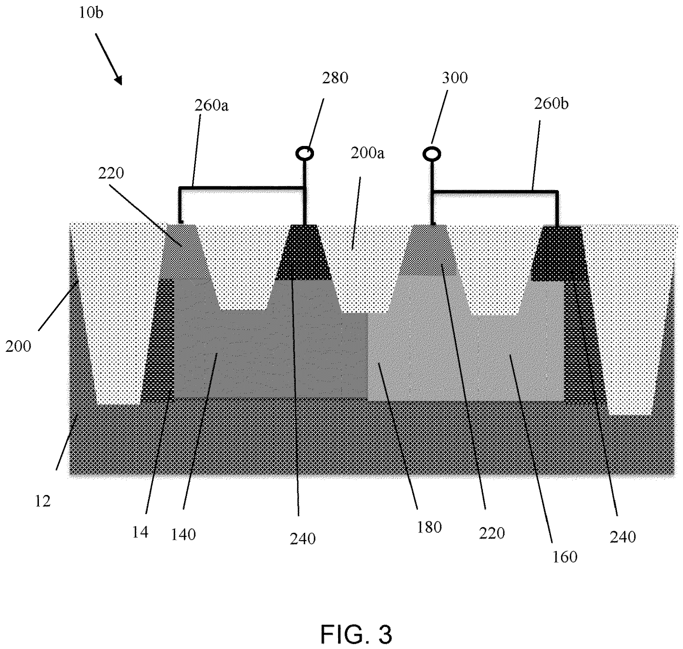

FIG. 3 shows an SCR device with porous semiconductor material. In particular, the structure 10b of FIG. 3 includes a semiconductor substrate 12 composed of any suitable material as already described herein. The semiconductor substrate 12 may include wells 140, 160. In embodiments, the well 140 may be an N-well and the well 160 may be a P-well. The wells 140, 160 may be formed by introducing different dopant types into the semiconductor substrate 12 by, for example, ion implantation processes. The porous semiconductor material 14 may be provided surrounding the wells 140, 160 within the semiconductor substrate 12. In more specific embodiments, the porous semiconductor material 14 may extend laterally surrounding both the wells 140, 160, below a top surface of the semiconductor substrate 12.

Still referring to FIG. 3, trench isolation structures 200, 200a may be provided within the semiconductor substrate 12. In embodiments, the trench isolation structures 200, 200a extend vertically into the wells 140, 160 and isolate diffusion regions 220, 240. In embodiments, the diffusion regions 220 are N+ diffusion regions and the diffusion regions 240 are P+ diffusion regions, each of which vertically extend into the semiconductor substrate 12 and, more specifically, within the wells 140, 160. In embodiments, the trench isolation structure 200a may be provided at a junction of the wells 140, 160. The trench isolation structure 200a may be a shallow trench isolation structure; whereas the trench isolation structure 200 may be a deep trench isolation structure, surrounding and isolating the wells 140, 160.

FIG. 3 also representatively shows contacts and/or wiring structures 260a to an anode 280 and contacts and/or wiring structures 260b to a cathode 300. In embodiments, the anode 280 is connected to the diffusion regions 220, 240 of the N-well 140 and the cathode 300 is connected to the diffusion regions 220, 240 of the P-well 16. The contacts and/or wiring structures 260a, 260b may contact silicide contacts on the diffusion regions 220, 240.

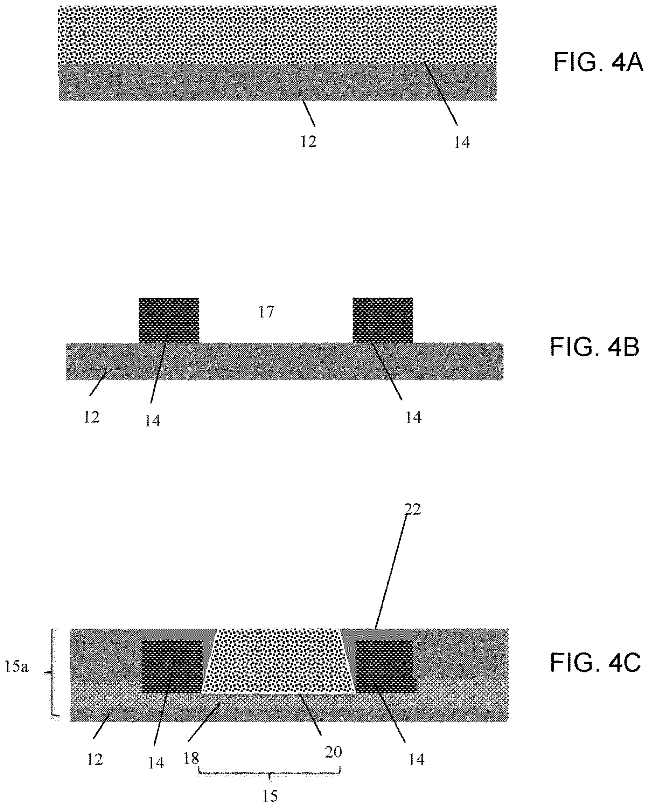

FIGS. 4A-4E show fabrication processes for manufacturing the device of FIG. 1 in accordance with aspects of the present disclosure. FIG. 4A shows the formation of the porous semiconductor material 14 formed from the semiconductor substate 12. As previously disclosed, the porous semiconductor material 14 may be formed by, for example, electrochemical anodization or chemical etching of the single-crystal semiconductor material of the semiconductor substate 12.

In FIG. 4B, the porous semiconductor material 14 is patterned using conventional CMOS technologies, e.g., conventional lithography, etching and deposition methods known to those of skill in the art. For example, a resist formed over the porous semiconductor material 14 is exposed to energy (light) and developed utilizing a conventional resist developer to form a pattern (opening). An etching process with a selective chemistry, e.g., RIE, will be used to transfer the pattern to the porous semiconductor material 14 and slightly into the semiconductor substate 12. In this way, the semiconductor substate 12 is slightly recessed. The resist is removed by a conventional oxygen ashing process or other known stripants.

In FIG. 4C, a collector implant (as shown by reference numeral 18) is provided in the semiconductor substate 12. In embodiments, the collector implant may be, for example, an n-type implant provided by a blanket implantation process. In embodiments, the n-type dopant may be arsenic (As), Phosphorus (P) or antimony (SB) as examples.

FIG. 4C further shows the fabrication of the collector region comprising defect free single crystalline semiconductor material 20. The defect free single crystalline semiconductor material 20 and defective semiconductor material 22 are both epitaxially grown from the semiconductor substrate 12, wherein the defect free single crystalline semiconductor material 20 comprises the collector region and the defective semiconductor material 22 forms in contact with the porous semiconductor material 14. The defect free single crystalline semiconductor material 20 may also be epitaxially grown over the exposed portions of the semiconductor substate 12 which are used for the collector contact region. As already described herein, the defective semiconductor material 22 may have, for example, a lattice mismatch or misfit dislocation compared to the defect free single crystalline semiconductor material 20.

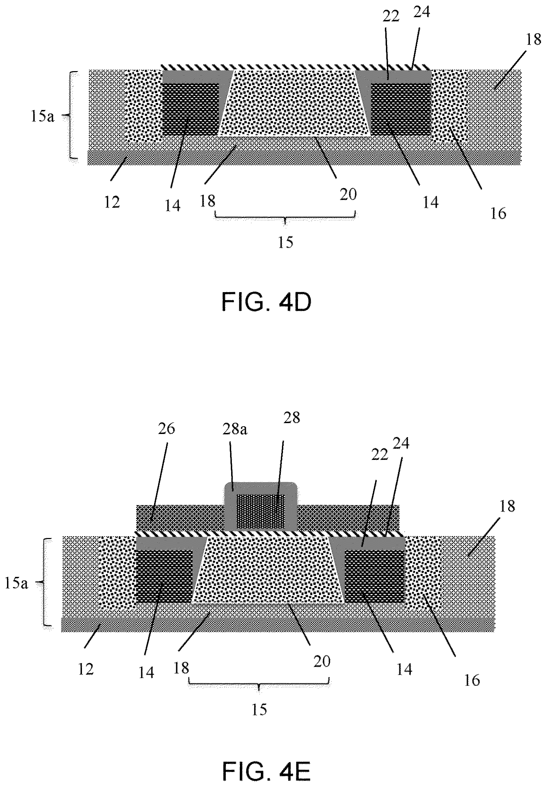

FIG. 4D shows formation of shallow trench isolation structures 16. The shallow trench isolation structures 16 may be formed by lithography, etching and deposition methods as already described herein and as is known to those of skill in the art. In embodiments, the shallow trench isolation structures 16 may be formed adjacent to and surrounding the porous semiconductor material 14. The shallow trench isolation structures 16 may be SiO₂ material. Following the deposition process, any excessive material may be removed from the semiconductor substrate 12 by a conventional CMP process.

FIG. 4D further shows formation of the intrinsic base region 24. In embodiments, the intrinsic base region 24 may be formed by an epitaxial growth process. The intrinsic base region 24 may be grown from and in direct contact with the of the defect free single crystalline semiconductor material 20 of the collector region 15. The intrinsic base region 24 will also grow over the defective semiconductor material 22. At least a portion of the intrinsic base region 24 contacting the defect free single crystalline semiconductor material 20 of the collector region 15 is surrounded by (or within the confines of) the porous semiconductor material 14.

The intrinsic base region 24 include a p-type dopant, e.g., boron. By way of example, through a masked ion implantation process, the p-type dopant may be introduced to the intrinsic base region 23. Illustratively, a patterned implantation mask may be used to define selected areas exposed for the implantation. The implantation masks may include a layer of a light-sensitive material, such as an organic photoresist, applied by a spin coating process, pre-baked, exposed to light projected through a photomask, baked after exposure, and developed with a chemical developer. The implantation mask has a thickness and stopping power sufficient to block masked areas against receiving a dose of the implanted ions. An annealing process may be performed to drive in the dopant into the semiconductor material of the intrinsic base region 24.

FIG. 4E shows the formation of the extrinsic base region 26, emitter 28, and collector contact region 15a. In embodiments, the collector contact region 15a may be formed by an ion implantation process, similar to that already described herein, e.g., n-type dopant as described in FIG. 4A used in the semiconductor substrate 12.

The emitter 28 may be formed by depositing and patterning an emitter material, e.g., Si material, using a self-aligned or non-self-aligned process as is known in the art such that no further description is required for a complete understanding of the present disclosure. The sidewall spacers 28a may be formed by a blanket deposition, e.g., CVD, of insulator material such as oxide or nitride, followed by an anisotropic etching process.

The extrinsic base region 26 may be epitaxially grown on the intrinsic base region 24 as is known in the art. As necessary, the extrinsic base region 26 and intrinsic base region 24 may be patterned after the deposition processes such that extrinsic base region 26 and intrinsic base region 24 are over the porous semiconductor material 14. The extrinsic base region 26 will surround the emitter 28 and be separated therefrom by the sidewall spacers 28a.

Referring back to FIG. 1, the contacts 32 are formed to the extrinsic base region 26, emitter 28, and collector contact region 15a. The contacts 32 may be formed by conventional back-end-of-line (BEOL) processes as described with respect to FIG. 1. For example, the BEOL processes include a deposition of the interlevel dielectric material 34, an etching process of the interlevel dielectric material 34 to expose the material of the extrinsic base region 26, emitter 28, and collector contact region 15a, followed by a silicide process and deposition of the conductive material, e.g., tungsten with TaN or TiN liner. Any residual conductive material on the interlevel dielectric material 34 may be removed by a CMP process.

The low capacitance, low resistance devices can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multi-chip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a semiconductor substrate;
a device comprising an active region; and
a porous semiconductor material within the semiconductor substrate and surrounding the active region of the device.

2. The structure of claim 1, wherein the porous semiconductor material comprises porous Si material.

3. The structure of claim 1 or claim 2, further comprising trench isolation structures surrounding the porous semiconductor material.

4. The structure of one of claims 1 to 3, wherein the device comprises a heterojunction bipolar transistor and the active region comprises a collector region surrounding the porous semiconductor material, and/or wherein the collector region comprises defect free single crystalline semiconductor material..

5. The structure of one of claims 1 to 4, wherein the device comprises a heterojunction bipolar transistor comprising a collector region separated from an extrinsic base region by an intrinsic base region, wherein at least the intrinsic base region comprises the active region surrounded by the porous semiconductor material.

6. The structure of claim 5, wherein the collector region comprises a defect free single crystalline semiconductor material and the intrinsic base region comprises a single crystalline semiconductor material in contact with the collector region and/or wherein the porous semiconductor material is under the active region.

7. The structure of claim 5, further comprising defective semiconductor material in contact with the porous semiconductor material and separating the porous semiconductor material from the intrinsic base region.

8. The structure of one of claims 1 to 3, wherein the device comprises a transistor and the active region comprises at least a channel region of a gate structure.

9. The structure of one of claims 1 to 3, wherein the device comprises a silicon controlled rectifier and the active region comprises at least wells connecting to an anode and a cathode.

10. A structure comprising:
a semiconductor material;
a heterojunction bipolar transistor comprising:
a collector region of defect free single crystalline semiconductor material over the semiconductor material;
an intrinsic base region above the collector region;
an extrinsic base region above the intrinsic base region; and
an emitter above the intrinsic base region; and
porous semiconductor material over the semiconductor material and surrounding at least the collector region.

11. The structure of claim 10, wherein the porous semiconductor material is under the intrinsic base region and comprises porous Si material, and/or wherein the intrinsic base region comprises a single crystalline semiconductor material, and/or wherein the porous semiconductor material surrounds the intrinsic base region.

12. The structure of claim 10 or 11, further comprising at least one of:
a defective semiconductor material between the porous semiconductor material and the intrinsic base region, and
trench isolation structures surrounding the porous semiconductor material.

13. The structure of claim 12, wherein the semiconductor material surrounds the porous semiconductor material and includes a collector contact region which is electrically connected to a contact, outside of the shallow trench isolation structures.

14. The structure of one of claims 10 to 13, wherein the extrinsic base material surrounds the emitter.

15. A method comprising:
forming a semiconductor substrate;
forming a device comprising an active region; and
forming a porous semiconductor material within the semiconductor substrate and surrounding the active region of the device.
